# EUROPEAN PATENT SPECIFICATION

(11) **EP 4 162 322 B1**
(45) Date of publication and mention of the grant of the patent: **28.10.2026**
(21) Application number: 21726348.2
(22) Date of filing: 07.05.2021
(51) Int. Cl.: G03F 1/36, G03F 1/70, G03F 7/20

(54) **SYSTEM FOR EXECUTING METHODS FOR GENERATING PATTERNING DEVICES AND PATTERNS THEREFOR**
SYSTEM ZUR DURCHFÜHRUNG VON VERFAHREN ZUR ERZEUGUNG VON MUSTERUNGSVORRICHTUNGEN UND MUSTER DAFÜR
SYSTEME D'EXECUTION DE PROCEDES POUR GÉNÉRER DES DISPOSITIFS DE FORMATION DE MOTIFS ET MOTIFS ASSOCIÉS

(30) Priority: 03.06.2020 US 202063034343 P; 10.06.2020 US 202063037513 P; 08.12.2020 US 202063122760 P
(43) Date of publication of application: 12.04.2023
(73) Proprietor: ASML Netherlands B.V., 5500 AH Veldhoven (NL)
(72) Inventor: HU, Jiuning, San Jose, California 95134 (US); YE, Jun, San Jose, California 95134 (US); LU, Yen-Wen, San Jose, California 95134 (US)
(74) Representative: ASML Netherlands B.V.
(86) International application number: PCT/EP2021/062102
(87) International publication number: WO 2021/244820

(56) References cited:
- WO-A1-2019/158682
- WO-A2-2007/033362
- US-A1- 2003 140 330
- US-A1- 2005 066 300
- US-A1- 2008 309 897
- US-A1- 2010 186 000
- US-A1- 2013 000 505
- US-A1- 2015 149 971

## Description

### CROSS-REFERENCE TO RELATED APPLICATIONS

This application claims priority of US application 63/034,343 which was filed on June 03, 2020, US application 63/037,513 which was filed on June 10, 2020 and US application 63/122,760 which was filed on December 08, 2020.

### TECHNICAL FIELD

The description herein relates generally to systems, products, and methods for generating patterning devices and pattern therefor. The present invention relates to a system for executing methods for generating patterning devices and patterns therefor.

### BACKGROUND

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatuses, the pattern on the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices as described herein can be gleaned, for example, from US 6,046,792.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

As noted, lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced while the amount of functional elements, such as transistors, per device has been steadily increasing over decades, following a trend commonly referred to as "Moore's law". At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-k1 lithography, according to the resolution formula CD = k1×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection optics" as used herein should be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the patterning device, and/or optical components for shaping, adjusting and/or projecting the radiation after the radiation passes the patterning device. The projection optics generally exclude the source and the patterning device.

US 2010/0186000 A1, US 2003/0140330 A1, WO 2019/158682 A1, US 2005/0066300 A1, WO 2007/033362 A2, US 2013/000505 A1, US 2015/0149971 A1 and US 2008/309897 A1 disclose background art.

### SUMMARY

According to an embodiment, there is provided a non-transitory computer readable medium having instructions that, when executed by a computer, cause the computer to execute a method for improving a design of a patterning device, the method comprising (i) obtaining mask points of a design of a mask feature, wherein the mask feature corresponds to a target feature in a target pattern to be printed on a substrate; and (ii) adjusting locations of the mask points to generate a modified design of the mask feature based on the adjusted mask points, wherein obtaining the mask points includes deriving the mask points from the target feature, wherein the deriving comprises associating the mask points with control points on the target feature to generate a first association between a first set of mask points and a first control point and a second association between a second set of mask points and a second control point.

According to an embodiment outside the scope of the present invention there is provided a non-transitory computer readable medium having instructions that, when executed by a computer, cause the computer to execute a method for improving a design of a patterning device, the method comprising: (i) obtaining mask points of a design of a mask feature, wherein the mask feature corresponds to a target feature in a target pattern to be printed on a substrate; and (ii) adjusting locations of the mask points to increase a process window, wherein the processing window is associated with a patterning process for printing the target pattern on a substrate, wherein the adjusting includes generating a modified design based on the adjusted locations.

According to an embodiment outside the scope of the present invention, there is provided a method for improving a design of a patterning device, the method comprising (i) obtaining mask points of a design of a mask feature, wherein the mask feature corresponds to a target feature in a target pattern to be printed on a substrate; and (ii) adjusting locations of the mask points to generate a modified design of the mask feature based on the adjusted mask points.

### BRIEF DESCRIPTION OF THE DRAWINGS

Figure 1 shows a block diagram of various subsystems of a lithography system.
Figure 2 shows example categories of processing variables.
Figure 3 schematically shows a flow for a patterning simulation method, according to an example.
Figure 4 schematically shows a flow for a measurement simulation method, according to an example.
Figure 5A is flow chart of a method for generating or improving a design of a mask feature corresponding to a target pattern, consistent with various embodiments.
Figure 5B is flow chart of a method for generating an initial design of the mask feature, consistent with various embodiments.
Figure 5C is a flow diagram of a process for optimizing the initial design of a mask feature, consistent with various embodiments.
Figure 6A illustrates a target feature with control points and initial mask points, consistent with various embodiments.
Figure 6B illustrates a design of a mask feature obtained from another process, consistent with various embodiments.
Figure 7 illustrates a process of applying a smoothing process to the mask points, consistent with various embodiments.
Figure 8 illustrates a perturbed version of the initial design of the mask feature, consistent with various embodiments.
Figure 9 illustrates an optimized design of a mask feature, consistent with various embodiments.
Figure 10A illustrates an example application of the point-based optimization process in which optimized designs of mask features are generated for target features of a first shape, consistent with various embodiments.
Figure 10B illustrates an example application of the point-based optimization process in which optimized designs of mask features are generated for target features of a second shape, consistent with various embodiments.
Figure 10C illustrates an example application of the point-based optimization process in which optimized designs of mask features are generated for target features and sub-resolution assist features (SRAFs), consistent with various embodiments.
Figure 10D illustrates an example application of the point-based optimization process in which optimized designs of mask features are generated for target features but not for SRAFs, consistent with various embodiments.
Figure 11 is a block diagram of an example computer system, according to an embodiment.
Figure 12 is a schematic diagram of a lithographic projection apparatus, according to an embodiment.
Figure 13 is a schematic diagram of another lithographic projection apparatus, according to an embodiment.
Figure 14 is a more detailed view of the apparatus in Figure 12, according to an embodiment.
Figure 15 is a more detailed view of the source collector module SO of the apparatus of Figure 13 and Figure 14, according to an embodiment.
Figure 16A illustrates a curvilinear design of a mask feature, consistent with various embodiments.
Figure 16B illustrates a polygonal design of a mask feature, consistent with various embodiments.
Figure 16C illustrates a curvilinear design and polygonal design of mask features, consistent with various embodiments.
Figure 16D illustrates a curvilinear design and polygonal design of mask features, consistent with various embodiments.
Figure 17 illustrates a hybrid design of a mask feature, consistent with various embodiments.
Figure 18 illustrates a flow diagram for performing an "all angle OPC" method described in Figure 5A may be implemented, consistent with various embodiments.

### DETAILED DESCRIPTION

In lithography, a patterning device (e.g., a mask) may provide a mask pattern (e.g., mask design layout) corresponding to a target pattern (e.g., target design layout), and this mask pattern may be transferred onto a substrate by transmitting light through the mask pattern. However, due to various limitations, the transferred pattern may appear with many irregularities and therefore, not be similar to the target pattern. Optical proximity correction (OPC) is an enhancement technique commonly used in designing the mask pattern to compensate for image errors due to diffraction or other process effects in lithography. Current OPC techniques enhance a design of a mask feature by adjusting segments of the design iteratively (e.g., to minimize a signal such as resist image or etch image signal) and stitch the corrected segments to form the corrected design. Some techniques enhance the design to optimize a cost function, e.g., edge placement error, mask rule check, symmetry, etc. Some techniques correct all segments together to optimize the cost function. Some techniques use image-base enhancement methods, such as freeform techniques in which a freeform mask design is generated from an initial image (e.g., Continuum transmission mask (CTM) image) and the freeform mask design is corrected iteratively to optimize image variable pixels. However, at least some of the current techniques are inefficient as they may suffer from convergence issues, may have limited process window size, may need users to tune many parameters to achieve the desired result, or may consume a significant amount of computing resources, e.g., runtime and memory, which prevents their use in production lines.

In the present disclosure, methods and systems are disclosed for improving a mask pattern using point-based OPC, or herein referred to as "all-angle OPC". In the point-based OPC, in some embodiments, initial mask points may be generated for a target feature from a target pattern and associated with the control points on the target feature, e.g., one control point is associated with one or more mask points. The mask points are adjusted (e.g., locations are changed) to generate a curvilinear pattern. The mask points can be moved along a specified direction (e.g., local normal to the curvilinear pattern or other predetermined direction) by a certain amount, e.g., to optimize a cost function at the control point. The above process of adjusting the mask points can be implemented iteratively to update the curvilinear pattern to achieve convergency.

In some embodiments, the point-based OPC provides the final or intermediate designs of the masks with curvilinear patterns, which are more natural than the elongated designs produced from the known techniques. In some embodiments, multiple mask points are moved coherently to optimize the cost function at one or more control points, which allows finer and more accurate control of the mask design locally and can possibly improve the overall lithography performance. In some embodiments, the association between control points and mask points are broken and reestablished, for example if the mask design becomes significantly different from the target feature, which enables optimizing at a control point more efficiently by intelligently selecting the mask points to be corrected (In contrast, in the prior art, the association between segments and control points are fixed even if the segments are already quite far away from the control point, e.g., near corners of target feature.). The all-angle OPC technique may be used to generate a curvilinear pattern or a non-curvilinear pattern (e.g., a polygonal pattern in which an angle between a segment or straight line of the pattern and a horizontal axis is 45*n degrees or 90*n degrees, where n is an integer) or a hybrid design (e.g., a design that is curvilinear in-part and polygonal in-part) for a mask feature.

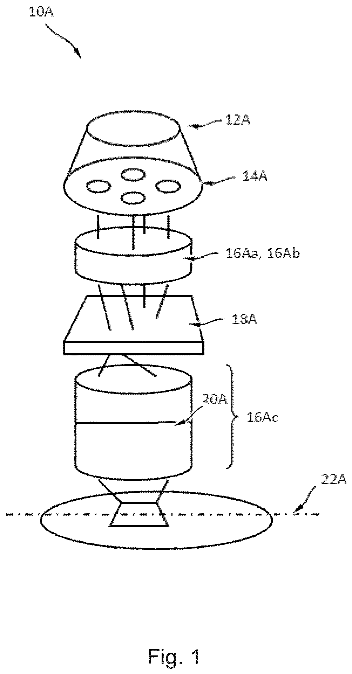

As a brief introduction, Fig. 1 illustrates an exemplary lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, e.g., define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin(Θmax), wherein n is the refractive index of the media between the substrate and the last element of the projection optics, and Θmax is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157360. The resist model is related only to properties of the resist layer (e.g., effects of chemical processes which occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251.

The patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. One or more of the design rule limitations may be referred to as "critical dimension" (CD). A critical dimension of a device can be defined as the smallest width of a line or hole or the smallest space between two lines or two holes. Thus, the CD determines the overall size and density of the designed device. Of course, one of the goals in device fabrication is to faithfully reproduce the original design intent on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include:
- a programmable mirror array. An example of such a device is a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means.
- a programmable LCD array. An example of such a construction is given in U.S. Patent No. 5,229,872.

One aspect of understanding a lithographic process is understanding the interaction of the radiation and the patterning device. The electromagnetic field of the radiation after the radiation passes the patterning device may be determined from the electromagnetic field of the radiation before the radiation reaches the patterning device and a function that characterizes the interaction. This function may be referred to as the mask transmission function (which can be used to describe the interaction by a transmissive patterning device and/or a reflective patterning device).

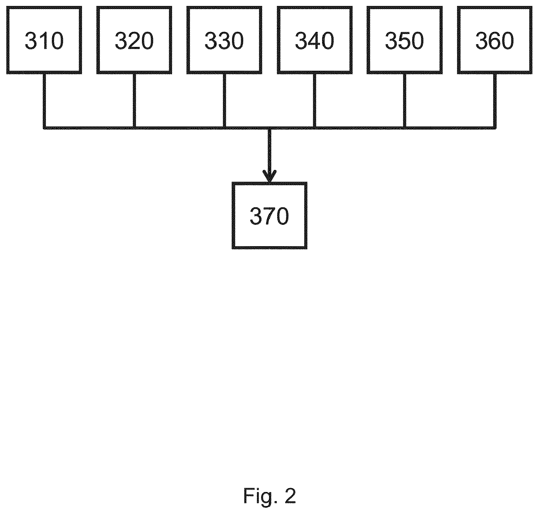

Variables of a patterning process are called "processing variables." The patterning process may include processes upstream and downstream to the actual transfer of the pattern in a lithography apparatus. Figure 2 shows example categories of the processing variables 370. The first category may be variables 310 of the lithography apparatus or any other apparatuses used in the lithography process. Examples of this category include variables of the illumination, projection system, substrate stage, etc. of a lithography apparatus. The second category may be variables 320 of one or more procedures performed in the patterning process. Examples of this category include focus control or focus measurement, dose control or dose measurement, bandwidth, exposure duration, development temperature, chemical composition used in development, etc. The third category may be variables 330 of the design layout and its implementation in, or using, a patterning device. Examples of this category may include shapes and/or locations of assist features, adjustments applied by a resolution enhancement technique (RET), CD of mask features, etc. The fourth category may be variables 340 of the substrate. Examples include characteristics of structures under a resist layer, chemical composition and/or physical dimension of the resist layer, etc. The fifth category may be characteristics 350 of temporal variation of one or more variables of the patterning process. Examples of this category include a characteristic of high frequency stage movement (e.g., frequency, amplitude, etc.), high frequency laser bandwidth change (e.g., frequency, amplitude, etc.) and/or high frequency laser wavelength change. These high frequency changes or movements are those above the response time of mechanisms to adjust the underlying variables (e.g., stage position, laser intensity). The sixth category may be characteristics 360 of processes upstream of, or downstream to, pattern transfer in a lithographic apparatus, such as spin coating, post-exposure bake (PEB), development, etching, deposition, doping and/or packaging.

As will be appreciated, many, if not all of these variables, will have an effect on a parameter of the patterning process and often a parameter of interest. Non-limiting examples of parameters of the patterning process may include critical dimension (CD), critical dimension uniformity (CDU), focus, overlay, edge position or placement, sidewall angle, pattern shift, etc. Often, these parameters express an error from a nominal value (e.g., a design value, an average value, etc.). The parameter values may be the values of a characteristic of individual patterns or a statistic (e.g., average, variance, etc.) of the characteristic of a group of patterns.

The values of some or all of the processing variables, or a parameter related thereto, may be determined by a suitable method. For example, the values may be determined from data obtained with various metrology tools (e.g., a substrate metrology tool). The values may be obtained from various sensors or systems of an apparatus in the patterning process (e.g., a sensor, such as a leveling sensor or alignment sensor, of a lithography apparatus, a control system (e.g., a substrate or patterning device table control system) of a lithography apparatus, a sensor in a track tool, etc.). The values may be from an operator of the patterning process.

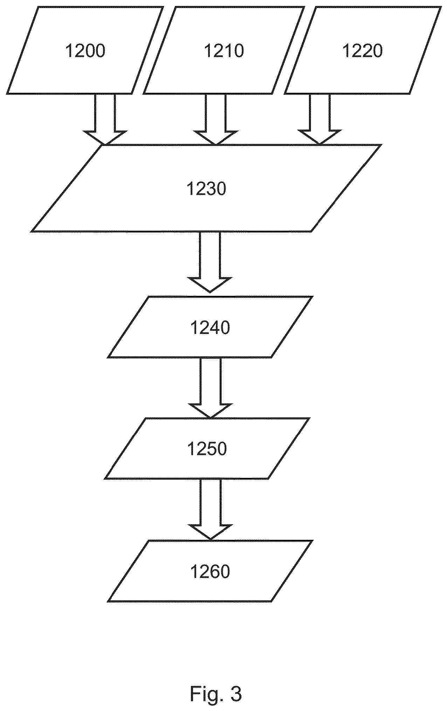

An exemplary flow chart for modelling and/or simulating parts of a patterning process is illustrated in Figure 3. As will be appreciated, the models may represent a different patterning process and need not comprise all the models described below. A source model 1200 represents optical characteristics (including radiation intensity distribution, bandwidth and/or phase distribution) of the illumination of a patterning device. The source model 1200 can represent the optical characteristics of the illumination that include, but not limited to, numerical aperture settings, illumination sigma (σ) settings as well as any particular illumination shape (e.g. off-axis radiation shape such as annular, quadrupole, dipole, etc.), where σ (or sigma) is outer radial extent of the illuminator.

A projection optics model 1210 represents optical characteristics (including changes to the radiation intensity distribution and/or the phase distribution caused by the projection optics) of the projection optics. The projection optics model 1210 can represent the optical characteristics of the projection optics, including aberration, distortion, one or more refractive indexes, one or more physical sizes, one or more physical dimensions, etc.

The patterning device / design layout model module 1220 captures how the design features are laid out in the pattern of the patterning device and may include a representation of detailed physical properties of the patterning device, as described, for example, in U.S. Patent No. 7,587,704. In an example, the patterning device / design layout model module 1220 represents optical characteristics (including changes to the radiation intensity distribution and/or the phase distribution caused by a given design layout) of a design layout (e.g., a device design layout corresponding to a feature of an integrated circuit, a memory, an electronic device, etc.), which is the representation of an arrangement of features on or formed by the patterning device. Since the patterning device used in the lithographic projection apparatus can be changed, it is desirable to separate the optical properties of the patterning device from the optical properties of the rest of the lithographic projection apparatus including at least the illumination and the projection optics. The objective of the simulation is often to accurately predict, for example, edge placements and CDs, which can then be compared against the device design. The device design is generally defined as the pre-OPC patterning device layout, and will be provided in a standardized digital file format such as GDSII or OASIS.

An aerial image 1230 can be simulated from the source model 1200, the projection optics model 1210 and the patterning device / design layout model 1220. An aerial image (AI) is the radiation intensity distribution at substrate level. Optical properties of the lithographic projection apparatus (e.g., properties of the illumination, the patterning device and the projection optics) dictate the aerial image.

A resist layer on a substrate is exposed by the aerial image and the aerial image is transferred to the resist layer as a latent "resist image" (RI) therein. The resist image (RI) can be defined as a spatial distribution of solubility of the resist in the resist layer. A resist image 1250 can be simulated from the aerial image 1230 using a resist model 1240. The resist model can be used to calculate the resist image from the aerial image, an example of which can be found in U.S. Patent Application Publication No. US 2009-0157360. The resist model typically describes the effects of chemical processes which occur during resist exposure, post exposure bake (PEB) and development, in order to predict, for example, contours of resist features formed on the substrate and so it typically related only to such properties of the resist layer (e.g., effects of chemical processes which occur during exposure, post-exposure bake and development). In an example, the optical properties of the resist layer, e.g., refractive index, film thickness, propagation and polarization effects- may be captured as part of the projection optics model 1210.

So, in general, the connection between the optical and the resist model is a simulated aerial image intensity within the resist layer, which arises from the projection of radiation onto the substrate, refraction at the resist interface and multiple reflections in the resist film stack. The radiation intensity distribution (aerial image intensity) is turned into a latent "resist image" by absorption of incident energy, which is further modified by diffusion processes and various loading effects. Efficient simulation methods that are fast enough for full-chip applications approximate the realistic 3-dimensional intensity distribution in the resist stack by a 2-dimensional aerial (and resist) image.

In an example, the resist image can be used an input to a post-pattern transfer process model module 1260. The post-pattern transfer process model 1260 defines performance of one or more post-resist development processes (e.g., etch, development, etc.).

Simulation of the patterning process can, for example, predict contours, CDs, edge placement (e.g., edge placement error), etc. in the resist and/or etched image. Thus, the objective of the simulation is to accurately predict, for example, edge placement, and/or aerial image intensity slope, and/or CD, etc. of the printed pattern. These values can be compared against an intended design to, e.g., correct the patterning process, identify where a defect is predicted to occur, etc. The intended design is generally defined as a pre-OPC design layout which can be provided in a standardized digital file format such as GDSII or OASIS or other file format.

Thus, the model formulation describes most, if not all, of the known physics and chemistry of the overall process, and each of the model parameters desirably corresponds to a distinct physical or chemical effect. The model formulation thus sets an upper bound on how well the model can be used to simulate the overall manufacturing process.

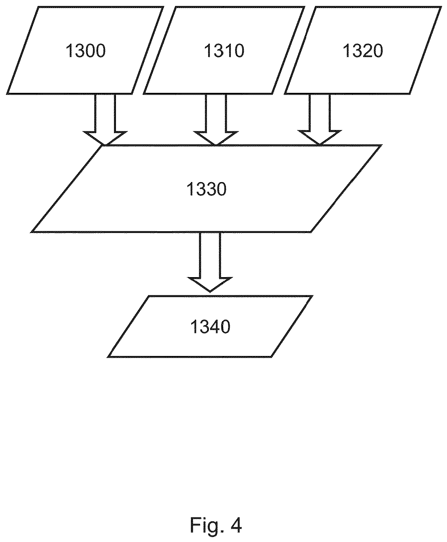

An exemplary flow chart for modelling and/or simulating a metrology process is illustrated in Figure 4. As will be appreciated, the following models may represent a different metrology process and need not comprise all the models described below (e.g., some may be combined). A source model 1300 represents optical characteristics (including radiation intensity distribution, radiation wavelength, polarization, etc.) of the illumination of a metrology target. The source model 1300 can represent the optical characteristics of the illumination that include, but not limited to, wavelength, polarization, illumination sigma (σ) settings (where σ (or sigma) is a radial extent of illumination in the illuminator), any particular illumination shape (e.g. off-axis radiation shape such as annular, quadrupole, dipole, etc.), etc.

A metrology optics model 1310 represents optical characteristics (including changes to the radiation intensity distribution and/or the phase distribution caused by the metrology optics) of the metrology optics. The metrology optics 1310 can represent the optical characteristics of the illumination of the metrology target by metrology optics and the optical characteristics of the transfer of the redirected radiation from the metrology target toward the metrology apparatus detector. The metrology optics model can represent various characteristics involving the illumination of the target and the transfer of the redirected radiation from the metrology target toward the detector, including aberration, distortion, one or more refractive indexes, one or more physical sizes, one or more physical dimensions, etc.

A metrology target model 1320 can represent the optical characteristics of the illumination being redirected by the metrology target (including changes to the illumination radiation intensity distribution and/or phase distribution caused by the metrology target). Thus, the metrology target model 1320 can model the conversion of illumination radiation into redirected radiation by the metrology target. Thus, the metrology target model can simulate the resulting illumination distribution of redirected radiation from the metrology target. The metrology target model can represent various characteristics involving the illumination of the target and the creation of the redirected radiation from the metrology, including one or more refractive indexes, one or more physical sizes of the metrology, the physical layout of the metrology target, etc. Since the metrology target used can be changed, it is desirable to separate the optical properties of the metrology target from the optical properties of the rest of the metrology apparatus including at least the illumination and projection optics and the detector. The objective of the simulation is often to accurately predict, for example, intensity, phase, etc., which can then be used to derive a parameter of interest of the patterning process, such overlay, CD, focus, etc.

A pupil or aerial image 1330 can be simulated from the source model 1300, the metrology optics model 1310 and the metrology target model 1320. A pupil or aerial image is the radiation intensity distribution at the detector level. Optical properties of the metrology optics and metrology target (e.g., properties of the illumination, the metrology target and the metrology optics) dictate the pupil or aerial image.

A detector of the metrology apparatus is exposed to the pupil or aerial image and detects one or more optical properties (e.g., intensity, phase, etc.) of the pupil or aerial image. A detection model module 1320 represents how the radiation from the metrology optics is detected by the detector of the metrology apparatus. The detection model can describe how the detector detects the pupil or aerial image and can include signal to noise, sensitivity to incident radiation on the detector, etc. So, in general, the connection between the metrology optics model and the detector model is a simulated pupil or aerial image, which arises from the illumination of the metrology target by the optics, redirection of the radiation by the target and transfer of the redirected radiation to the detectors. The radiation distribution (pupil or aerial image) is turned into detection signal by absorption of incident energy on the detector.

Simulation of the metrology process can, for example, predict spatial intensity signals, spatial phase signals, etc. at the detector or other calculated values from the detection system, such as an overlay, CD, etc. value based on the detection by the detector of the pupil or aerial image. Thus, the objective of the simulation is to accurately predict, for example, detector signals or derived values such overlay, CD, corresponding to the metrology target. These values can be compared against an intended design value to, e.g., correct the patterning process, identify where a defect is predicted to occur, etc.

Thus, the model formulation describes most, if not all, of the known physics and chemistry of the overall metrology process, and each of the model parameters desirably corresponds to a distinct physical and/or chemical effect in the metrology process.

Various patterns on or provided by a patterning device may have different process windows. i.e., a space of processing variables under which a pattern will be produced within a specification. Examples of pattern specifications that relate to potential systematic defects include checks for necking, line pull back, line thinning, CD, edge placement, overlapping, resist top loss, resist undercut and/or bridging. Typically, a process window is defined over two processing variables i.e., dose and focus such that the CD obtained after patterning may be within ±10% of the desired CD of a feature of the pattern. The process window of all the patterns on a patterning device or an area thereof may be obtained by merging (e.g., overlapping) process windows of each individual pattern.

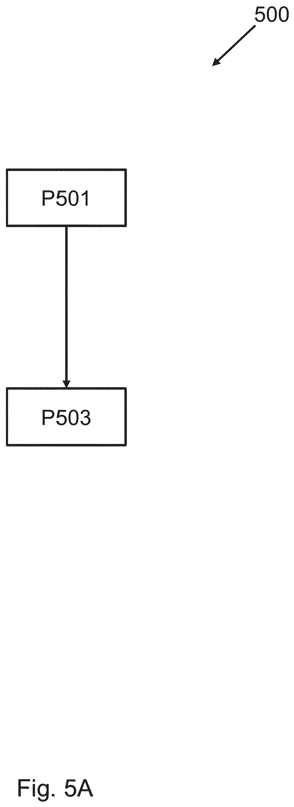

Figure 5A is flow chart of an exemplary method 500 for generating or improving a design of a mask feature corresponding to a target pattern to be printed on a substrate via a patterning process involving a lithographic process, consistent with various embodiments. In an embodiment, the target pattern may be a binary design layout, a continuous tone design layout, or a design layout of another suitable form. The target pattern includes one or more target features to be printed on the substrate, and the mask pattern includes mask features corresponding to the one or more target features. In some embodiments, a design of the target feature may be a polygon, and a design of the corresponding mask feature may be a curvilinear pattern. A mask feature may be a main feature which corresponds to the target feature or a sub-resolution assist feature (SRAF).

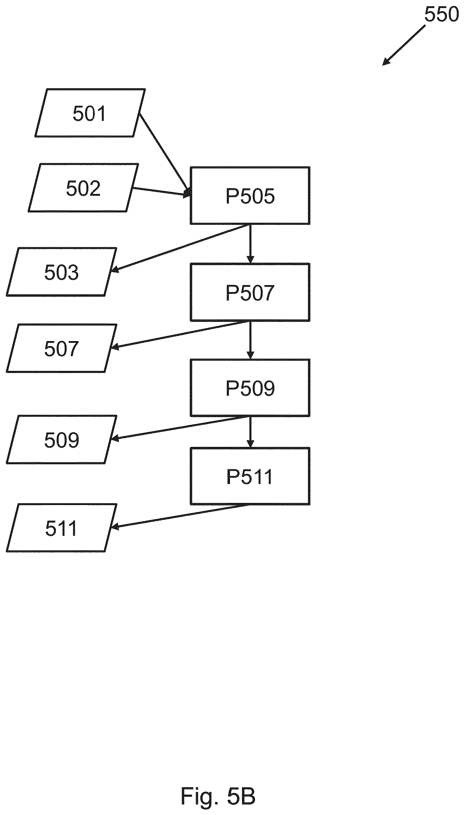

At process P501, mask points of a design of a mask feature are obtained. In some embodiments, the mask points are a set of points located on the mask feature. The mask points can be adjusted (e.g., moved to a different location) to modify the design of the mask feature. The mask points are either derived from an existing design of the mask feature, or derived from the target feature, in which case the mask points are (smoothly) connected with lines to form an initial design. In some embodiments, the initial design is of a curvilinear pattern. Additional details of obtaining the mask points or generating the initial design is described at least with reference to process 550 of FIG. 5B.

At process P503, the initial design is optimized by adjusting the locations of the mask points. The adjusting of the locations of the mask points generates a modified design of the mask feature (hence referred to as "point-based optimization process"). In some embodiments, the location of the mask points is adjusted such that a cost function is optimized. The cost function can include one or more of an edge placement error (EPE), a simulated signal such as a resist image signal (or etch image signal), mask rule check (MRC) penalty, process window, etc. The process P503 may use one or more cost functions, and different cost functions may be optimized in different ways.

For example, the process P503 may optimize the cost function such as the EPE by reducing the EPE (e.g., until minimized) of one or more target features. In some embodiments, an EPE is a distance between a point on a contour in the resist image (e.g., contour corresponding to the mask feature) to an intended position of that point (e.g., a control point on the target feature).

In another example, the process P503 may optimize the cost function such as the simulated signal by reducing the simulated signal (e.g., until minimized) on one or more target features. In some embodiments, the simulated signal can be obtained from a resist image (or an etch image), which can be obtained, e.g., simulated using a resist model (or an etch model), from the modified design of the mask feature.

In another example, the process P503 may optimize the cost function such as the MRC violation penalty by reducing the MRC violation penalty (e.g., until minimized). In some embodiments, the MRC is an image regularization method for reducing the complexity of the mask patterns that may be generated. MRC refers to the limiting conditions of a mask manufacturing process or apparatus. A penalty may be a term of the cost function that depends on a violation amount, e.g., a difference between a mask measurement and a given MRC or mask parameter (for example, a mask pattern width and an allowed (e.g., minimum or maximum) mask pattern width).

In another example, the process P503 may optimize the cost function such as the process window by increasing the process window (e.g., until maximized). In some embodiments, increasing the process window includes increasing the range of dose or focus values. In some embodiments, a process window of a patterning process includes a range of values for source parameters, such as dose and focus, of a lithographic apparatus that is used to print the target pattern on the substrate using the mask pattern.

In some embodiments, the process P503 of adjusting the location is an iterative process and the iterations of adjusting the locations are performed until a specified condition is satisfied. The specified condition can be that a predefined number of iterations are performed, or the cost function is optimized. Further, the modified design is updated in every iteration (e.g., by adjusting locations of one or more mask points) and the output of the final iteration, e.g., the final modified design, may be used for manufacturing the mask pattern. The mask pattern may have additional structural features, such as SRAFs corresponding to the modified design. The mask pattern may then be used to transfer the modified design to the substrate using a lithographic apparatus.

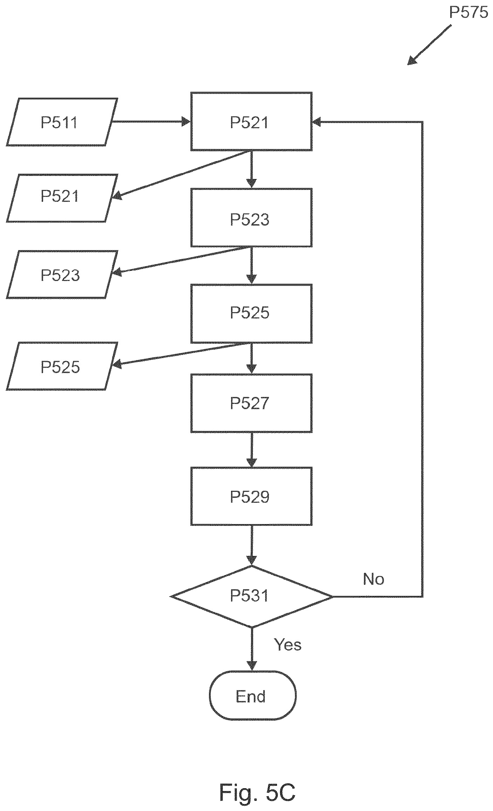

Additional details with respect to optimizing the initial design of the mask feature are described at least with reference to process 575 of FIG. 5C.

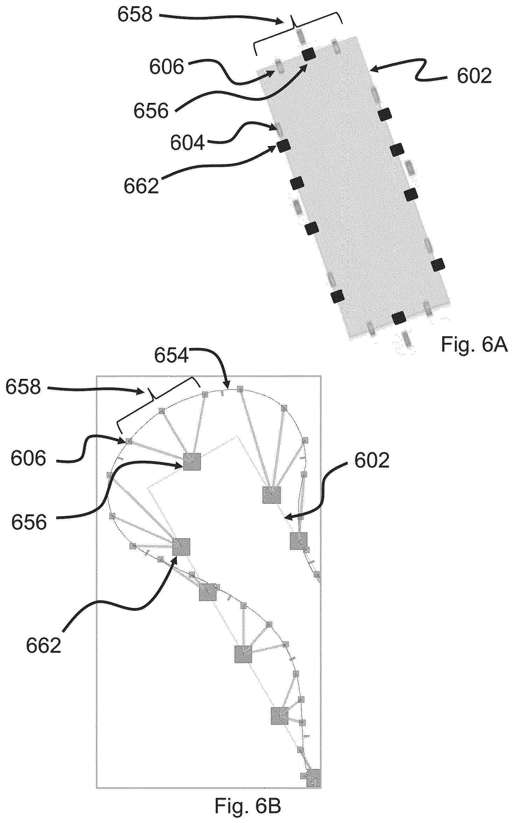

Figure 5B is flow chart of a method 550 for generating an initial design of the mask feature, consistent with various embodiments. In some embodiments, the process 550 is performed as part of the process P501 of the process 500. At process P505, a target pattern 501 is obtained. The target pattern 501 includes one or more target features such as target feature 602 of FIG. 6A.
Figure 6A illustrates a target feature with control points and initial mask points, consistent with various embodiments. The target features can be of any shape, e.g., a circle, an ellipse, a polygon, etc. For example, the target feature 602 is rectangle in shape. Continuing with process P505, the target feature 602 is associated with a number of control points, such as control point 656 and control point 662. In some embodiments, the control points are associated with the target feature 602 by segmenting the target feature 602 into a number of segments and placing one or more control points on the edges of the target feature 602 in each of the segments. In the example of FIG. 6A, a control point 656 and another similar control point is placed on the mid-point of the shorter edges of the target feature 602, and some control points, including control point 662, are placed on longer edges of the target feature 602. In some embodiments, the control points on the target feature can be placed at user-defined locations on one or more edges of a target feature.

A number of mask points 503, such as mask points 604 and 606, are derived from the target feature 602. The mask points 503 are a set of points that form a design of a mask feature corresponding to the target feature 602. The mask points 503 may be connected using a line (e.g., curved or straight) to form a design of the mask feature. In some embodiments, the mask points 503 are connected using a curved line to form a curvilinear design. In some embodiments, the process of deriving the mask points 503 from the target feature 602 includes generating the mask points 503 at user-defined locations, e.g., on or near the target feature 602. As illustrated in FIG. 6A, some mask points, such as mask point 604, are located on the edges of the target feature 602, and some mask points, such as mask point 606, are located near the edges or corners of the target feature 602. The mask points 503 may be adjusted, e.g., by changing the locations of the mask points, to update the design (e.g., as described at least with reference to FIG. 5C below).

A point-based OPC process may start with an initial design of the mask feature that is generated in various ways. For example, the initial design of the mask feature may be generated from the target feature 602, e.g., by using the mask points 503 derived from the target feature 602 (as further described below). In another example, an input design 502 of the mask feature may be provided to the process P505. The input design 502 may be obtained from, or generated using, another OPC process. Examples of such OPC processes include machine learning freeform OPC, CTM Freeform OPC, CTM+ Freeform OPC, segment-based OPC, Inverse lithography technology (ILT), machine learning (ML)-based OPC, etc. Figure 6B illustrates a design of a mask feature obtained from another process, consistent with various embodiments. The design 654 (e.g., input design 502) of the mask feature may be generated from the target feature 602 using one of the above OPC processes. Further, the design 654 may be curvilinear in shape. In an event the process receives the design 654 as the input design 502, the mask points 503 are derived from the design 654. For example, the mask points 503 can be a set of points at user-defined locations, e.g., on the design 654.

At process P507, the mask points 503 are associated with the control points to generate a number of control point-mask point associations 507. For example, a first association is generated between a set of mask points 658 and a control point 656. The association may be generated based on user-defined inputs. For example, a user may select the set of mask points 658 to be associated with the control point 656. In some embodiments, the associations are generated such that each control point is associated with the same number of mask points. For example, as illustrated in FIG. 6B, each control point is associated with three mask points (the association between the mask points and a control point is depicted using edges connecting the mask points and the corresponding control point). In some embodiments, a cost function is optimized at a control point by adjusting the locations of one or more mask points associated with the control point as described at least with reference to FIG. 5C below. Further, the associations between the mask points and the control points may change during the process of adjusting the locations as described at least with reference to FIG. 5C below.

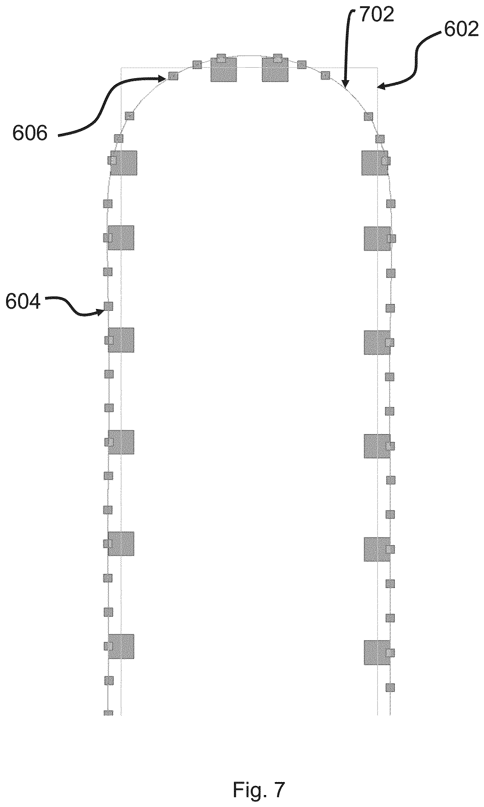

At process P509, a smoothing process is applied to the mask points 503 to generate a design 509 of the mask feature. In some embodiments, the smoothing process may include applying curve fitting, which is a process of constructing a curve that has the best fit to a series of data points (e.g., subject to constraints). Curve fitting can involve either interpolation, where an exact fit to the data is required, or smoothing, in which a "smooth" function is constructed that approximately fits the data. Figure 7 illustrates a process of applying a smoothing process to the mask points, consistent with various embodiments. In FIG. 7, a smoothing process is applied to the mask points 503 (e.g., mask points 604 and 606) to generate a curvilinear pattern 702 (e.g., design 509).

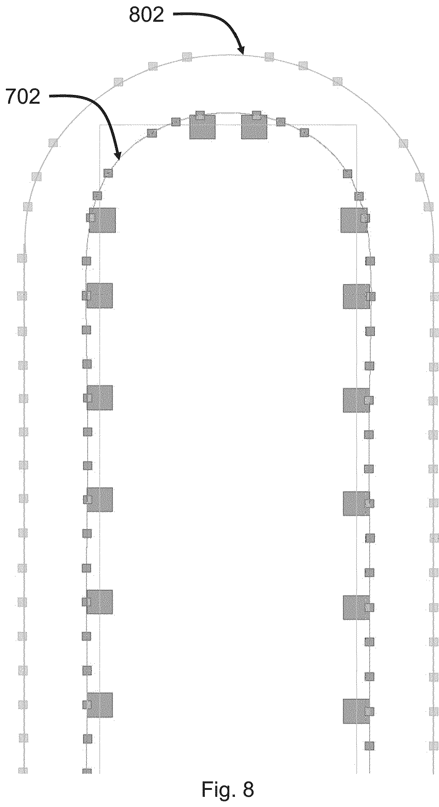

At process P511, a perturbation process is applied to the design 509 to generate an enlarged (or shrunken) design 511, which is an enlarged (or shrunken) version of the design 509. In some embodiments, the perturbation process enlarges (or shrinks) the design 509 by moving each of the mask points (e.g., by a specified distance) in a specified direction (e.g., local normal). Figure 8 illustrates a perturbed version of the initial design of the mask feature, consistent with various embodiments. For example, by applying a perturbation process to the curvilinear pattern 702 (e.g., design 509 generated by the smoothing process), an enlarged version 802 of the curvilinear pattern 702 is generated. The enlarged version 802 may be input to the design optimization process of FIG. 5C as an initial design 511 of the mask feature.

Figure 5C is a flow diagram of a process 575 for optimizing a design of a mask feature, consistent with various embodiments. In some embodiments, the process 575 is performed as part of process P503 of process 500. At process P521, the initial design 511 is received as an input. A process model, such as a resist and etch model, is applied to the initial design to obtain a simulated image (e.g., resist image or etch image), and a cost function 521 is computed using the simulated image. **In** some embodiments, the cost function 521 is determined for each of the control points associated with the target feature 602. As described above, the cost function 521 can be one or more of the EPE, the simulated signal, process window etc. For example, a cost function such as the EPE may be determined using the simulated image by extracting a contour of the mask feature from the simulated image and comparing the contour with the target feature 602 to obtain the EPE at a control point.

At process P523, location adjustment data 523 of the mask points 503 is determined for each control point based at least in part on the cost function 521. **In** some embodiments, the location adjustment data 523 can include a slope and distance value by which one or more mask points associated with a control point has to be moved in order to optimize the cost function 521 (e.g., reduce or minimize the EPE). For example, the location adjustment data 523 for the control point 656 can indicate the direction (e.g., direction such as local normal to the design or other direction) and the distance by which one or more mask points from the set of mask points 658 have to be moved to minimize the EPE at the control point 656. The determination of the location adjustment data 523 may also consider the current location of the mask points associated with the control point and geometrical information (e.g., shape) of the target feature. For example, the determination of the location adjustment data 523 for the control point 656 may consider the current location of the set of mask points 658 and geometrical information (e.g., shape) of the target feature 602.

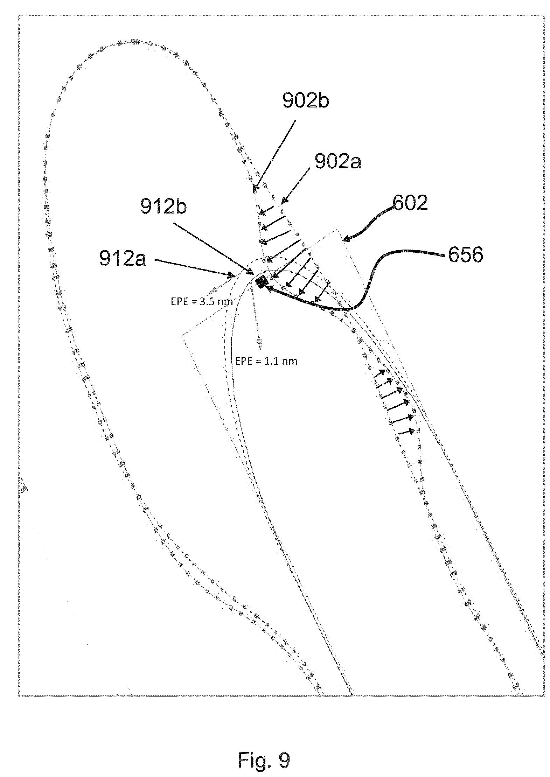

At process P525, the location of the one or more mask points associated with each control point is adjusted based on the location adjustment data 523 to optimize the cost function 521. Upon adjusting the location of the one or more mask points, a modified design 525 is generated, e.g., as illustrated in FIG. 9.

Figure 9 illustrates an optimized design of a mask feature, consistent with various embodiments. Upon adjusting the location of the one or more mask points of the initial design 511, a modified design 902a (e.g., modified design 525) is generated. Note that FIG. 9 illustrates that the cost function 521, such as the EPE, at a control point 656 is reduced from an initial value to "3.5 nm" by moving one or more mask points 658 in relation to the control point 656. **In** some embodiments, the EPE is determined by obtaining a simulated image (e.g., resist image or etch image) from the modified design 902a, extracting a contour 912a from the simulated image and measuring the distance between a point on the contour 912a and the control point 656. **In** some embodiments, in adjusting the mask points, the process may split the design into a number of fragments (e.g., arc fragments) and then apply adjustments to the fragments of the design. For example, multiple mask points may be adjusted collectively (e.g., coherently), or individually (e.g., separately).

At process P527, a smoothing process is applied to the modified design 902a. As described above, the smoothing process can be a curve fitting process, which constructs a curve that has the best fit to a series of data points (e.g., the adjusted mask points).

At process P529, an MRC process is applied to the modified design 902a to further update the modified design 902a to ensure that the modified design 902a complies with the limiting conditions of a mask manufacturing process or apparatus (for example, a mask design width is within an allowed (e.g., minimum or maximum) mask design width).

At determination process P531, a determination is made whether an optimization condition is satisfied. If the optimization condition is satisfied (e.g., cost function 521 is optimized or a predefined number of iterations is performed), the process 575 concludes. If the optimization condition is not satisfied, the modified design 902a is input to process P521 and the process 575 is repeated to optimize the cost function 521 further by adjusting the mask points and generating another modified design. In some embodiments, the process 575 of optimizing a design of the mask feature (e.g., initial design 511 or the modified design 902a) is an iterative process and the iteration (e.g., such as the above processes of P521 to P529) is repeated until the cost function 521 is optimized or a predefined number of iterations is performed with each iteration generating a modified design by adjusting one or more mask points. After several iterations, a final modified mask design 525 is generated. In some embodiments, the cost function 521 associated with the final modified design 525 is optimized. For example, in FIG. 9 after several iterations, a final modified design 902b (e.g., final modified design 525) is generated. Note that the cost function 521, such as the EPE, in the final modified design 902b at the control point 656 is "1.1 nm", which is less than the EPE of "3.5 nm" in the initial iteration. That is, the EPE is reduced (e.g., cost function 521 optimized) as the number of iterations increases. In some embodiments, the EPE of " 1.1 nm" may not be optimized further and therefore, the modified design 902b may be considered as the final optimized design of the mask feature corresponding to the target feature 602. In some embodiments, the EPE is determined by obtaining the contour 912b (e.g., from the simulated image as described above) and measuring the distance between a point on the contour 912b and the control point 656.

In some embodiments, while optimizing the modified design 525 over several iterations, the association between the mask points and the control points may be either "fixed" or "dynamic." For example, in a fixed mode, if a first set of mask points are associated with a first control point in a first iteration, the first set of mask points remain associated with the first control point in all the iterations. In a dynamic mode, if a first set of mask points are associated with a first control point in a first iteration, one or more mask points from the first set of mask points may be associated with a second control point in a second iteration in order to optimize the cost function 521. That is, an existing association between the mask points and the control points can be broken and new associations can be established. Such dynamic adjustment would be helpful in various scenarios, e.g., if the modified design becomes significantly different from the shape of the target feature (which can be determined by comparing the modified design with the target feature). In this way, the cost function 521 at a control point can be optimized more effectively by intelligently selecting the mask points to be corrected.

In yet another association mode, referred to as "soft" mode, there may be no defined associations between the mask points and the control points. A mask point may be adjusted based on the cost function 521 associated with each of the control points that are within certain distance of the mask point. In some embodiments, the "soft" mode of association chosen may depend on the geometry of the target feature 602. For example, the amount of mask point adjustment may depend on the distances between the mask point and the control points and the angles between the local normal at mask point and the straight lines connecting the mask point and control points.

While the foregoing description of optimizing the cost function 521 is described with reference to EPE, other cost functions such as the simulated signal or the process window may also be used. If the cost function 521 is the simulated signal, the process 575 may adjust the location of the mask points to optimize the simulated signal by reducing the simulated signal (e.g., until minimized). In another example, if the cost function 521 is the process window, the process 575 may adjust the location of the mask points to optimize the process window by increasing the process window (e.g., until maximized). In yet another example, if the cost function 521 is a combination of one or more metrics, such as the EPE and the process window, the process 575 may adjust the location of the mask points to optimize the EPE and the process window by reducing the EPE (e.g., until minimized) and increasing the process window (e.g., until maximized). In some embodiments, a cost function such as the simulated signal or EPE is a local cost function, e.g., cost function local to a control point, while a cost function such as a process window is a global cost function, which is related to one or more target features on a whole. In some embodiments, a conflict may arise in optimizing both local and global cost functions in which case the optimization is achieved via a compromise (e.g., one or more local cost functions may not be optimized while the other local cost functions or global cost may be optimized, or vice versa). For example, if the simulated signal or EPE at one control point is affected by the simulated signal or EPE at another control point, e.g., a neighboring control point, both the local cost functions may not be optimized at the same time and a compromised optimization may be adopted, such as one of them may be optimized or both of them may be optimized to an extent (e.g., EPE reduced but not minimized) one does not affect the other.

While the foregoing description describes optimizing a design of a single mask feature, a mask pattern may have a number of such mask features corresponding to a number of target features in a target pattern. The point-based optimization process (e.g., process 500) may be performed for all the mask features in the mask pattern to generate an optimized design for the corresponding mask features. The mask pattern having the optimized designs of the mask features, such as the optimized design 902b, may then be used in manufacturing a mask that may be used in transferring the mask pattern to a substrate.

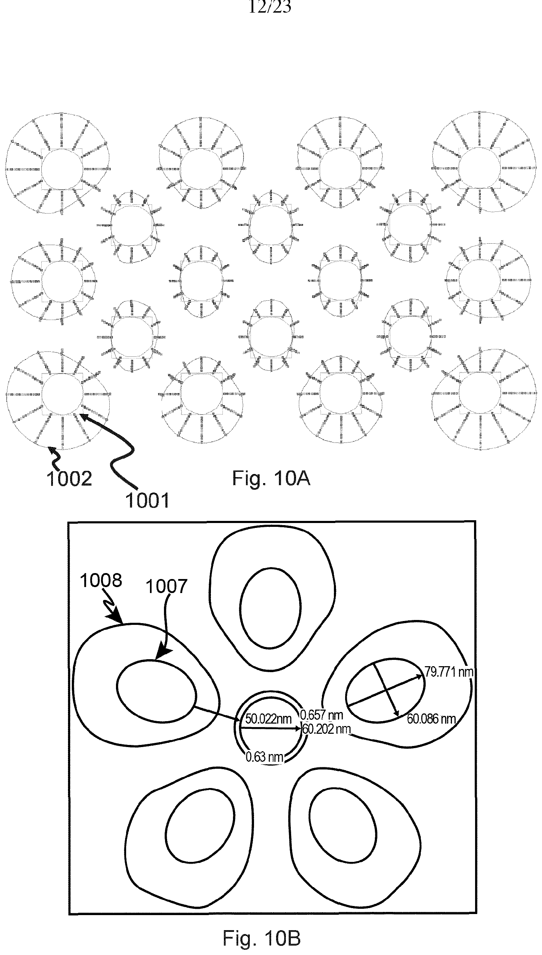

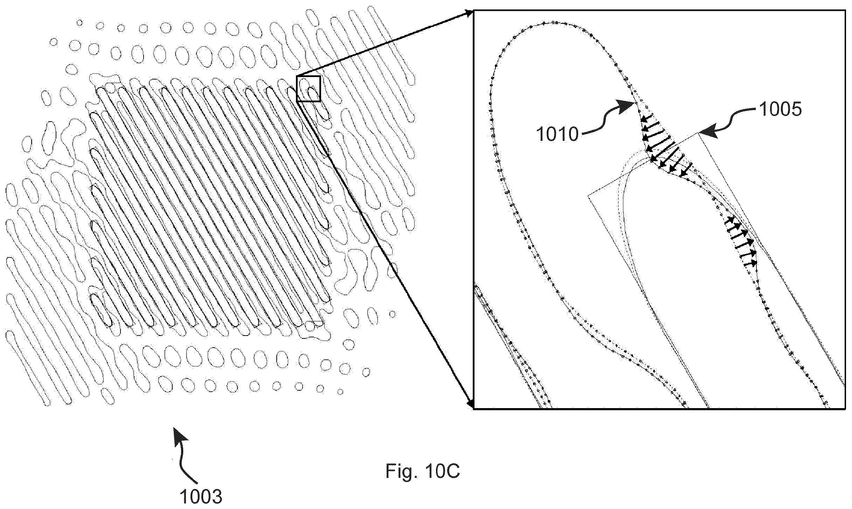

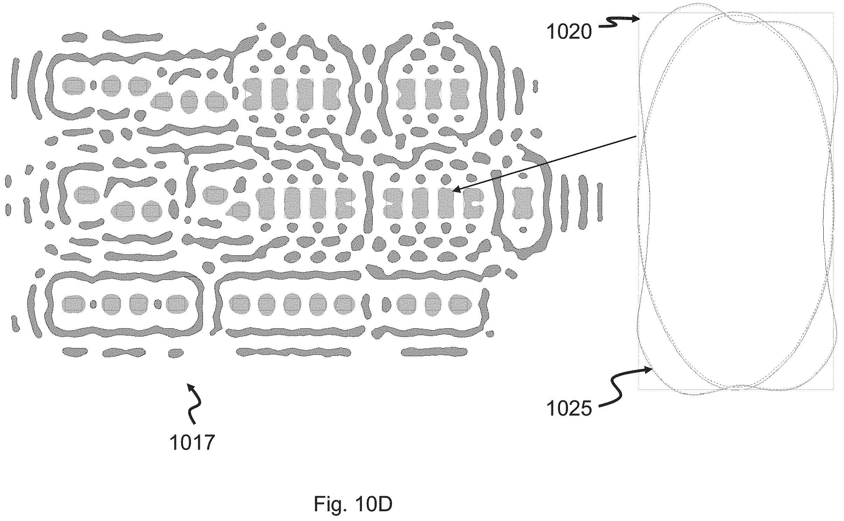

The point-based optimization process of generating or optimizing the design of a mask feature can be used in various applications. Figures 10A-10D illustrate various example applications of the design optimization process, consistent with various embodiments. Figure 10A illustrates an example application of the point-based optimization process in which optimized designs (e.g., optimized design 1002) of mask features are generated for target features such as the illustrated squares (e.g., target feature 1001). Figure 10B illustrates an example application of the point-based optimization process in which optimized designs (e.g., optimized design 1008) of mask features are generated for target features such as circles and ellipses (e.g., target feature 1007). Figure 10C illustrates an example application of the point-based optimization process in which optimized designs of mask features are generated for target features such as oblique patterns. In FIG. 10C, the point-based optimization process does not separate different types of mask features, such as the main features (e.g., target features) and SRAFs, that is, the optimized designs are generated for both the main features and the SRAFs. For example, a mask pattern 1003 includes mask features that correspond to the main features (e.g., target features) and SRAFs. The point-based optimization process generates an optimized design 1010 of the mask feature corresponding to the target feature 1005. In FIG. 10D, the point-based optimization process separates the different types of mask features and generates optimized designs of the mask features for the main features but not for the SRAFs. For example, a mask pattern 1017 includes mask features that correspond to both the main features (e.g., target features) and SRAFs. The point-based optimization process generates an optimized design 1025 of the mask feature corresponding to the target feature 1020.

While the point-based optimization process can generate an initial design of the mask feature from a target feature and optimize the initial design, the point-based optimization process can also be used to improve designs of mask features that are generated by other OPC processes, such as a Freeform process. In the examples of FIG. 10C and 10D, initial designs of the mask features are generated using the Freeform process, which are then input to the point-based optimization process for optimizing them to the optimized designs 1010 and 1025.

In some embodiments, the point-based optimization process is more efficient than other OPC processes. For example, the point-based optimization process can optimize the cost function in lesser number of iterations than the other processes, thereby minimizing the computing resources, e.g., processor runtime and memory, consumed in generating the optimized design. In another example, the point-based optimization process achieves better optimization of the cost function compared to the other OPC processes while consuming lesser computing resources, e.g., processor runtime and memory, than the other processes.

In some embodiments, using the point-based optimization process in combination with other OPC processes is more efficient than using the other OPC processes without the point-based optimization process. That is, the initial designs are generated using other OPC processes, which are then optimized using the point-based optimization process to achieve increased efficiency. For example, the point-based optimization process can generate the optimized design from the initial design by consuming lesser computing resources, e.g., processor runtime and memory, than the other processes would have consumed in generating the optimized design without using the point-based optimization process. Further, the point-based optimization process may achieve better optimization of the cost function compared to the other OPC processes would have achieved without using the point-based optimization process.

In some embodiments, the point-based optimization process can be incorporated into a Source Mask Optimization (SMO) flow by optimizing the mask points position together with the source of a lithographic apparatus to optimize the process window. For example, in each iteration of SMO, the direction and amount of each mask point moved may depend on the source shape which is also optimized in the same SMO iteration. The mask output from SMO is then composed of the optimized mask points that are smoothly connected (e.g., using smoothing process).

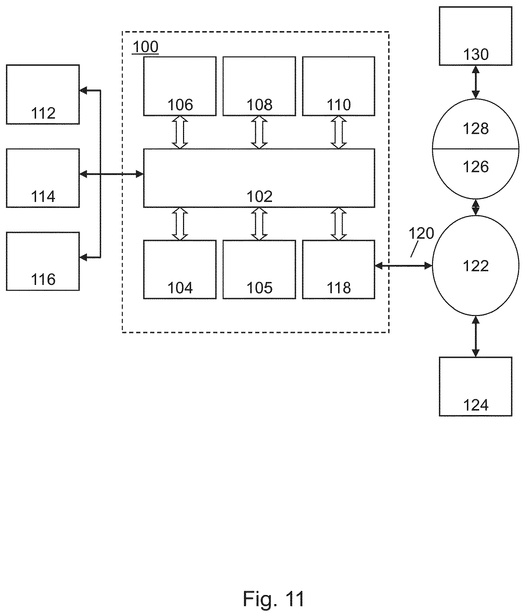

Fig. 11 is a block diagram that illustrates a computer system 100 which can assist in implementing the methods, flows or the apparatus disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random-access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. One such downloaded application may provide all or part of a method described herein, for example. The received code may be executed by processor 104 as it is received, and/or stored in storage device 110, or other non-volatile storage for later execution. In this manner, computer system 100 may obtain application code in the form of a carrier wave.

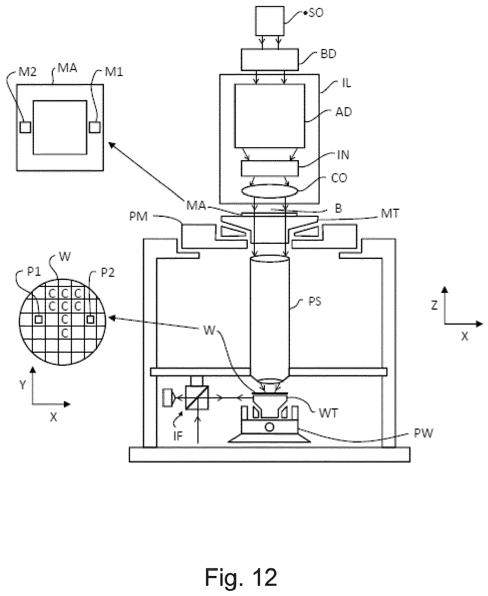

Fig. 12 schematically depicts an exemplary lithographic projection apparatus in conjunction with the techniques described herein can be utilized. The apparatus comprises:
- an illumination system IL, to condition a beam B of radiation. In this particular case, the illumination system also comprises a radiation source SO;
- a first object table (e.g., patterning device table) MT provided with a patterning device holder to hold a patterning device MA (e.g., a reticle), and connected to a first positioner to accurately position the patterning device with respect to item PS;
- a second object table (substrate table) WT provided with a substrate holder to hold a substrate W (e.g., a resist-coated silicon wafer), and connected to a second positioner to accurately position the substrate with respect to item PS;
- a projection system ("lens") PS (e.g., a refractive, catoptric or catadioptric optical system) to image an irradiated portion of the patterning device MA onto a target portion C (e.g., comprising one or more dies) of the substrate W.

As depicted herein, the apparatus is of a transmissive type (i.e., has a transmissive patterning device). However, in general, it may also be of a reflective type, for example (with a reflective patterning device). The apparatus may employ a different kind of patterning device to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

It should be noted with regard to Fig. 12 that the source SO may be within the housing of the lithographic projection apparatus (as is often the case when the source SO is a mercury lamp, for example), but that it may also be remote from the lithographic projection apparatus, the radiation beam that it produces being led into the apparatus (e.g., with the aid of suitable directing mirrors); this latter scenario is often the case when the source SO is an excimer laser (e.g., based on KrF, ArF or F2 lasing).

The beam PB subsequently intercepts the patterning device MA, which is held on a patterning device table MT. Having traversed the patterning device MA, the beam B passes through the lens PL, which focuses the beam B onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the patterning device MA with respect to the path of the beam B, e.g., after mechanical retrieval of the patterning device MA from a patterning device library, or during a scan. In general, movement of the object tables MT, WT will be realized with the aid of a long-stroke module (coarse positioning) and a short-stroke module (fine positioning), which are not explicitly depicted in Fig. 12. However, in the case of a stepper (as opposed to a step-and-scan tool) the patterning device table MT may just be connected to a short stroke actuator, or may be fixed.

The depicted tool can be used in two different modes:
- In step mode, the patterning device table MT is kept essentially stationary, and an entire patterning device image is projected in one go (i.e., a single "flash") onto a target portion C. The substrate table WT is then shifted in the x and/or y directions so that a different target portion C can be irradiated by the beam PB;
- In scan mode, essentially the same scenario applies, except that a given target portion C is not exposed in a single "flash". Instead, the patterning device table MT is movable in a given direction (the so-called "scan direction", e.g., the y direction) with a speed v, so that the projection beam B is caused to scan over a patterning device image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

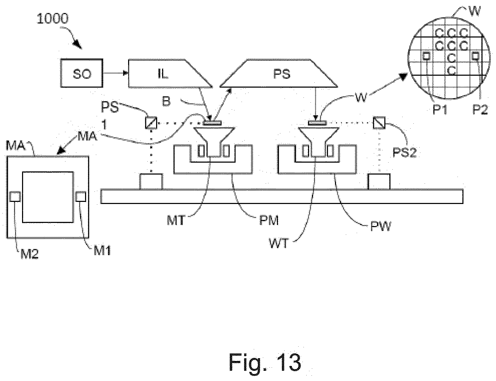

Figure 13 schematically depicts another exemplary lithographic projection apparatus 1000 in conjunction with the techniques described herein can be utilized.

The lithographic projection apparatus 1000 comprises:
- a source collector module SO
- an illumination system (illuminator) IL configured to condition a radiation beam B (e.g. EUV radiation).
- a support structure (e.g. a patterning device table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus 1000 is of a reflective type (e.g. employing a reflective patterning device). It is to be noted that because most materials are absorptive within the EUV wavelength range, the patterning device may have multilayer reflectors comprising, for example, a multi-stack of Molybdenum and Silicon. In one example, the multi-stack reflector has a 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Fig. 13, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. The source collector module SO may be part of an EUV radiation system including a laser, not shown in Fig. 13, for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases the source may be an integral part of the source collector module, for example when the source is a discharge produced plasma EUV generator, often termed as a DPP source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus 1000 could be used in at least one of the following modes:
1. In step mode, the support structure (e.g. patterning device table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.
2. In scan mode, the support structure (e.g. patterning device table) MT and the substrate table WT are scanned synchronously while a pattern imparted to the radiation beam is projected onto a target portion C (i.e. a single dynamic exposure). The velocity and direction of the substrate table WT relative to the support structure (e.g. patterning device table) MT may be determined by the (de-)magnification and image reversal characteristics of the projection system PS.
3. In another mode, the support structure (e.g. patterning device table) MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

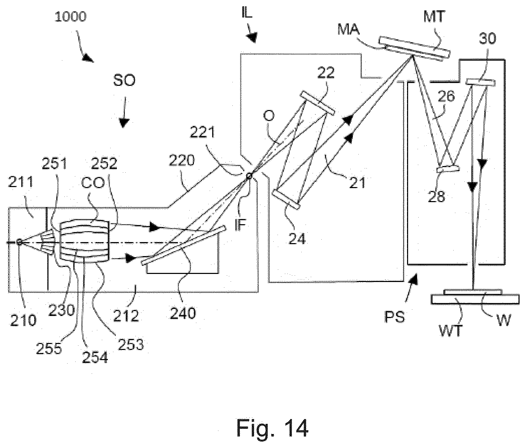

Fig. 14 shows the apparatus 1000 in more detail, including the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Fig. 12.

Collector optic CO, as illustrated in Fig. 12, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

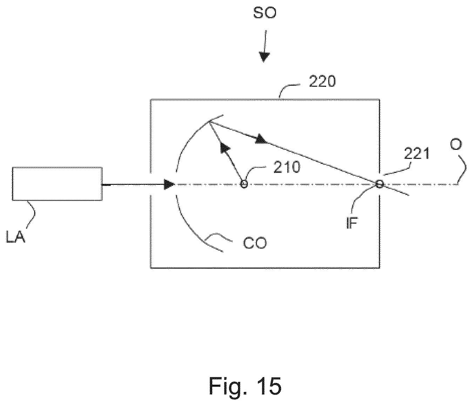

Alternatively, the source collector module SO may be part of an LPP radiation system as shown in Fig. 15. A laser LA is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

As described above at least with reference to FIGS. 5A-10D, the "all angle OPC" technique generates a curvilinear pattern for a mask feature corresponding to a target feature in the target pattern. The curvilinear pattern is generated by adjusting mask points, which may be derived from an input mask feature or a corresponding target feature, until a cost function is optimized. In some embodiments, the "all angle OPC" technique may generate a non-curvilinear design (e.g., a polygonal pattern in which an angle between a segment or straight line of the pattern and a horizontal axis is 45*n degrees or 90*n degrees, where n is an integer) or a hybrid design (e.g., a design that is curvilinear in-part and polygonal in-part) for a mask feature. Further, such designs may be generated for a mask feature that may be (a) a main feature which corresponds to the target feature or (b) a SRAF. Note that the term "polygonal design" or "polygonal pattern" used in this disclosure refers to a pattern in which an angle between a segment or a straight line of the pattern and a horizontal axis is 45*n degrees or 90*n degrees, where n is an integer. In some embodiments, the polygonal pattern may be generated using the methods described at least with reference to FIGs. 5A-5C by adjusting the mask points such that an angle between two straight lines of a final design (e.g., final modified design 525 or 902b) is 45*n degrees or 90*n degrees. For example, a smoothing process described at least with reference to FIG. 5B or a cost function 521 described at least with reference to FIG. 5C, which is used to determine location adjustment data of the mask points, may be adapted to generate a polygonal or hybrid design instead of a curvilinear design for the mask feature.

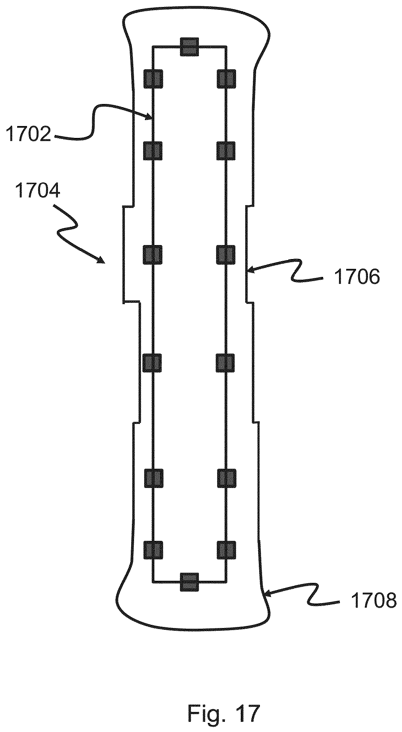

The type of design (e.g., curvilinear, polygonal or hybrid) to be generated may be determined based on one or more parameters. In some embodiments, the mask feature may be generated as a polygonal or hybrid design based on a user preference. For example, the user may choose to generate the mask features as polygonal or hybrid design instead of curvilinear design to minimize a complexity in manufacturing a patterning device with curvilinear designs. In some embodiments, the mask feature may be generated as a polygonal or hybrid design to optimize the cost function (e.g., EPE, MRC violation penalty) better than that may be achieved with a curvilinear design. For example, a cost function, such as EPE, may be reduced to a first value when the mask feature is generated using the curvilinear design, but may be reduced even further to a second value (second value < first value) when the mask feature is generated with the polygonal or hybrid design. In some embodiments, the mask feature may be generated as a polygonal or hybrid design when the target pattern has a dense arrangement of target features and generating curvilinear design may violate one or more MRC constraints such as a mask feature size, width, distance between two mask features, or other MRC constraints. For example, the distance between two mask features may be less than a minimum distance threshold when the mask features are generated as curvilinear designs, but may be equal to or more than the minimum distance threshold when the mask features are generated as polygonal or hybrid designs. In some embodiments, the mask feature may be generated as a curvilinear design for a specified portion of a target feature and as a polygonal design for other portions of the target feature. For example, the mask feature may be generated as a curvilinear design for a portion of the target feature proximate to one or more vertices or line ends of the target feature, and as a polygonal design for a remaining portion of the target feature (e.g., as illustrated in FIG. 17). In some embodiments, the mask feature may be generated as polygonal or hybrid design instead of curvilinear design to minimize the computing resources consumed in generating the curvilinear design.

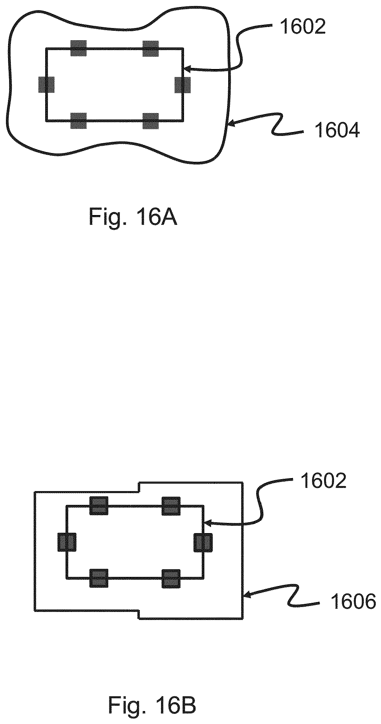

Figure 16A illustrates a curvilinear design of a mask feature, consistent with various embodiments. A mask feature 1604, which corresponds to a target feature 1602, is generated as a curvilinear design. In some embodiments, the mask feature 1604 is similar to the modified design 902b of FIG. 9 and the target feature 1602 is similar to the target feature 602.

Figure 16B illustrates a polygonal design of a mask feature, consistent with various embodiments. A mask feature 1606, which corresponds to the target feature 1602, is generated as a polygonal design (e.g., a design constructed using straight lines). In some embodiments, the mask feature 1606 is generated in a way similar to the methods described at least with reference to FIGs. 5A-10D, except that the mask feature 1606 is generated as a polygon and not as a curvilinear pattern.

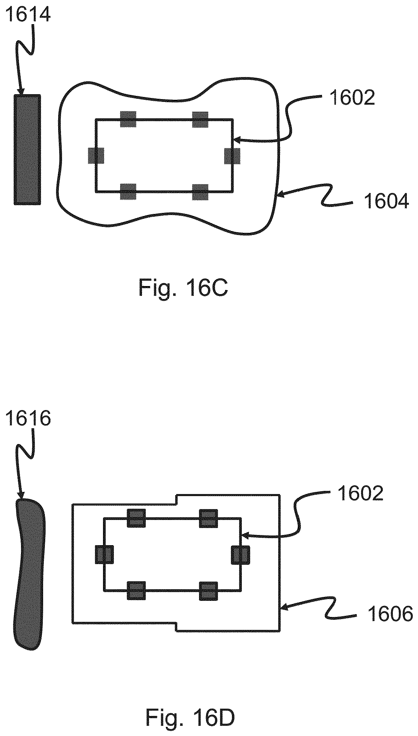

Figure 16C illustrates a curvilinear design and polygonal design of mask features, consistent with various embodiments. The mask feature 1604, which corresponds to the target feature 1602, is generated as a curvilinear design. A mask feature 1614, which corresponds to a SRAF, is generated as a polygonal design.

Figure 16D illustrates a curvilinear design and polygonal design of mask features, consistent with various embodiments. The mask feature 1606, which corresponds to the target feature 1602, is generated as a polygonal design, whereas a mask feature 1616, which corresponds to a SRAF, is generated as a curvilinear design.

Figure 17 illustrates a hybrid design of a mask feature, consistent with various embodiments. A mask feature 1704, which corresponds to a target feature 1702, is generated as a hybrid design in which a first portion 1706 is generated as a polygonal design and a second portion 1708 (e.g., proximate to vertices of target feature 1702) is generated as a curvilinear design. In some embodiments, the mask feature 1704 is similar to the modified design 902b of FIG. 9 (except that the mask feature 1704 is generated as a polygon and curvilinear pattern) and the target feature 1702 is similar to the target feature 602.

While FIGs. 16C and 16D show specific combinations of the designs for mask features, such as curvilinear design for main mask feature 1604 and polygonal design for SRAF mask feature 1614 in FIG. 16C, and polygonal design for main mask feature 1606 and curvilinear design for SRAF mask feature 1616 in FIG. 16D, various other combinations are also possible. For example, both main mask feature and SRAF mask feature may be of the same design. In another example, the design of the main mask feature may be different from that of the SRAF mask feature. In yet another example, no SRAF mask features may be generated.

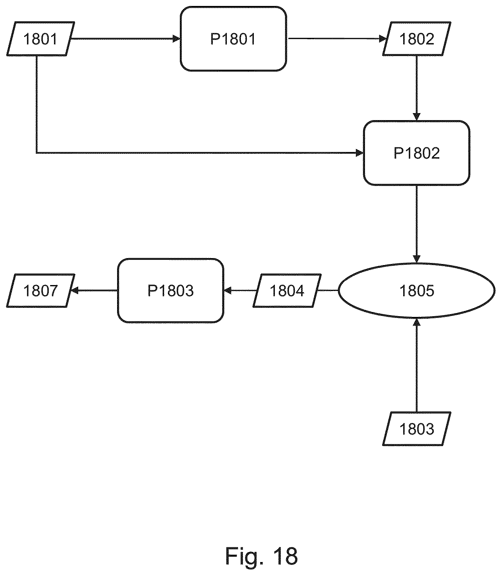

FIG. 18 illustrates a flow diagram for performing an "all angle OPC" method described in FIG. 5A, consistent with various embodiments.

At process P1801, a number of clips 1801, which are target images corresponding to target patterns are input to a CTM engine to perform OPC on the clips 1801 to generate CTM or CTM+ mask images 1802. In some embodiments, the CTM engine may perform multiple stages of CTM and CTM+ on the clips 1801 to obtain the mask images 1802 as optimized OPC results. The mask images 1802 may contain both main features and SRAFs. The mask images 1802 may be used as ground truth for training a machine learning (ML) model 1805 to generate a mask pattern (e.g., post OPC) for any given target pattern.

At process P1802, the clips 1801 and the mask images 1802 are provided to the ML model 1805 as a training dataset to train the ML model 1805. In some embodiments, training the ML model 1805 may be an iterative process and each iteration may include determining a cost function that is indicative of a difference between a predicted mask pattern (e.g., mask pattern generated by the ML model 1805) and a mask image that is input to the ML model 1805, and adjusting parameters of the ML model 1805 to minimize the cost function. The ML model 1805 is considered to be trained when the cost function is minimized (e.g., the difference between the predicted mask pattern and the input mask image is less than a threshold). After the ML model 1805 is well trained, the ML model 1805 may be used to generate a mask pattern for any given target pattern.

A target image 1803 of a target pattern is input to the trained ML model 1805 to obtain a mask pattern 1804 for the target pattern. In some embodiments, the mask pattern 1804 generated by the ML model 1805 may not be optimized (e.g., EPE may not be optimized).

At process P1803, the mask pattern 1804 is input to an all-angle OPC module that performs an all-angle OPC method (e.g., as described at least with reference to FIGS. 5A-5C) to improve the mask pattern 1804 and generate an improved mask pattern 1807. In some embodiments, the improved mask pattern 1807 is similar to the final modified mask design 525 of FIG. 5C. In some embodiments, the improved mask pattern 1807 may be optimized (e.g., EPE may be optimized). Further, the mask pattern 1807 may have a curvilinear, polygonal, or hybrid design.

In some embodiments, the all-angle OPC technique is different from Freeform OPC in that the all angle OPC generates the mask pattern by adjusting the mask points associated with a mask pattern whereas the Freeform OPC generates the mask pattern by adjusting pixel values in an image corresponding to the design layout. Further, in prior segment-based OPC methods, while the segment angles are preserved (e.g., segments are limited to having an angle of 45*n degrees, where n is an integer), the number of mask points used for adjusting the mask pattern may not be preserved. In contrast, in all-angle OPC technique, neither the number of mask points nor the angle between segments of the mask pattern may be preserved during the adjustment process as the mask points may be added or deleted during the adjustment process and the angle between segments can be any angle (e.g., any degree such as "0"-"360" degrees for curvilinear design, and 45*n or 90*n degrees for a polygonal design). Additionally, in all-angle OPC technique, a mask point may be moved in any direction as opposed to the segment-based OPC method in which the edge segments of the mask pattern are adjusted along the segment normal direction.

In some embodiments, the all-angle OPC technique may combined with other OPC techniques in generating a mask pattern. Each technique may be used to generate a different mask feature of the mask pattern or a different portion of the mask feature and each technique may be used to generate a polygonal design or a curvilinear design. For example, for the target feature 1602 illustrated in FIG. 16D, a segment-based OPC or image-based OPC technique may be used to generate the mask feature 1606 and the all-angle OPC technique may be used to generate the mask feature 1616.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The concepts disclosed herein may simulate or mathematically model any generic imaging system for imaging sub wavelength features, and may be especially useful with emerging imaging technologies capable of producing wavelengths of an increasingly smaller size. Emerging technologies already in use include EUV (extreme ultraviolet) lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus which may specifically take the form of a programmable computer running a computer program arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C. Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

## Claims

1. A non-transitory computer-readable medium having instructions that, when executed by a computer, cause the computer to execute a method for improving a design (509, 511) of a patterning device, the method comprising:
obtaining mask points (503, 604, 606, 658) of the design (509, 511) of a mask feature, wherein the mask feature is associated with a target feature (602) in a target pattern (501) to be printed on a substrate (W); and
adjusting locations of the mask points (503, 604, 606, 658) to generate a modified design (525, 902a, 902b) of the mask feature based on the adjusted mask points (503, 604, 606, 658),
wherein obtaining the mask points (503, 604, 606, 658) includes:
deriving the mask points (503, 604, 606, 658) from the target feature (602), wherein the deriving comprises associating the mask points (503, 604, 606, 658) with control points (656) on the target feature (602) to generate a first association between a first set of mask points (658) and a first control point (656) and a second association between a second set of mask points and a second control point.

2. The computer-readable medium of claim 1, wherein adjusting locations of the mask points (503, 604, 606, 658) is an iterative process, wherein each iteration includes:
determining a cost function (521) associated with an optical proximity correction process or a source mask optimization process,
determining, for each control point (656) on the target feature (602), location data of the mask points (503, 604, 606, 658) based on the cost function (521), and
adjusting a location of one or more of the mask points (503, 604, 606, 658) based on the location data to optimize the cost function (521), wherein the adjusting includes updating the modified design (525, 902a, 902b).

3. The computer-readable medium of claim 2, wherein determining the cost function (521) includes:
performing a simulation with the modified design (525, 902a, 902b) to obtain a resist image signal or an etch image signal as the simulated signal, and
determining the simulated signal for each control point (656) on the target feature (602), and wherein the adjusting is based on the simulated signal at the control point (656) and the association of mask points (503, 604, 606, 658) with the control point (656).

4. The computer-readable medium of claim 2, wherein determining the cost function (521) includes:
performing a simulation with the modified design (525, 902a, 902b) to obtain a simulated image;
obtaining the process window using the simulated image, wherein the process window includes a range of focus and dose values for which the target pattern (501) printed on a substrate (W) using the modified design (525, 902a, 902b) satisfies a predetermined specification.

5. The computer-readable medium of claim 2, wherein the cost function (521) includes at least one of an edge placement error, a simulated signal, a process window, or a mask rule check violation penalty.

6. The computer-readable medium of claim 1, wherein adjusting the locations of the mask points (503, 604, 606, 658) includes:
modifying associations between the mask points (503, 604, 606, 658) and the control points (656) for a next iteration of mask point adjustment.

7. The computer-readable medium of claim 1, wherein one or more control points (656) on the target feature (602) is associated with different set of mask points in at least two iterations.

8. The computer-readable medium of claim 1, further comprising:
applying a smoothing process to the mask points (503, 604, 606, 658), wherein the smoothing process performs curve fitting to connect the mask points (503, 604, 606, 658) with curves to generate the design (509) of the patterning device as a first curvilinear pattern.

9. The computer-readable medium of claim 8 further comprising:
performing image perturbation on the design (509) of the patterning device to generate an enlarged version of the design (511).

10. The computer-readable medium of claim 2, wherein adjusting the location of one or more of the mask points (503, 604, 606, 658) includes adjusting a set of the mask points (503, 604, 606, 658) coherently.

11. The computer-readable medium of claim 2, wherein adjusting the location of one or more of the mask points (503, 604, 606, 658) includes adjusting each of a set of the mask points (503, 604, 606, 658) individually.

12. The computer-readable medium of claim 2, wherein the location data of each mask point includes a slope value and a distance value by which a location adjustment of the corresponding mask point is to be performed in relation to a control point (656) with which the corresponding mask point is associated.

13. The computer-readable medium of claim 1, wherein the design (511) is resultant from one or more of: machine learning, ML, based optimal proximity correction , OPC, continuous transmission mask, CTM, Freeform OPC, CTM+ Freeform OPC, segment-based OPC, and Inverse lithography technology.

14. The computer-readable medium of claim 1, wherein the mask feature is a sub-resolution assist feature or a main feature.

## Patentansprüche

1. Ein nichttransitorisches computerlesbares Medium, das Anweisungen aufweist, die bei Ausführung durch einen Computer bewirken, dass der Computer ein Verfahren zur Verbesserung eines Entwurfs (509, 511) einer Musterungsvorrichtung ausführt, wobei das Verfahren Folgendes beinhaltet:
Erhalten von Maskenpunkten (503, 604, 606, 658) des Entwurfs (509, 511) eines Maskenstrukturelements, wobei das Maskenstrukturelement einem Zielstrukturelement (602) in einem Zielmuster (501), das auf ein Substrat (W) gedruckt werden soll, zugeordnet ist; und
Anpassen von Orten der Maskenpunkte (503, 604, 606, 658) zum Erzeugen eines modifizierten Entwurfs (525, 902a, 902b) des Maskenstrukturelements auf der Basis der angepassten Maskenpunkte (503, 604, 606, 658),
wobei das Erhalten der Maskenpunkte (503, 604, 606, 658) Folgendes umfasst:
Ableiten der Maskenpunkte (503, 604, 606, 658) von dem Zielstrukturelement (602), wobei das Ableiten das Zuordnen der Maskenpunkte (503, 604, 606, 658) zu Kontrollpunkten (656) auf dem Zielstrukturelement (602) beinhaltet, um eine erste Zuordnung zwischen einem ersten Satz Maskenpunkten (658) und einem ersten Kontrollpunkt (656) und eine zweite Zuordnung zwischen einem zweiten Satz Maskenpunkten und einem zweiten Kontrollpunkt zu erzeugen.

2. Computerlesbares Medium gemäß Anspruch 1, wobei das Anpassen von Orten der Maskenpunkte (503, 604, 606, 658) ein iterativer Prozess ist, wobei jede Iteration Folgendes umfasst:
Bestimmen einer Kostenfunktion (521), die einem Prozess optischer Nahbereichskorrektur oder einem Prozess der Quellenmaskenoptimierung zugeordnet ist,
Bestimmen, für jeden Kontrollpunkt (656) auf dem Zielstrukturelement (602), von Ortsdaten der Maskenpunkte (503, 604, 606, 658) auf der Basis der Kostenfunktion (521), und
Anpassen eines Ortes eines oder mehrerer der Maskenpunkte (503, 604, 606, 658) auf der Basis der Ortsdaten, um die Kostenfunktion (521) zu optimieren, wobei das Anpassen das Aktualisieren des modifizierten Entwurfs (525, 902a, 902b) umfasst.

3. Computerlesbares Medium gemäß Anspruch 2, wobei das Bestimmen der Kostenfunktion (521) Folgendes umfasst:
Durchführen einer Simulation mit dem modifizierten Entwurf (525, 902a, 902b), um ein Resistbildsignal oder ein Ätzbildsignal als das simulierte Signal zu erhalten, und
Bestimmen des simulierten Signals für jeden Kontrollpunkt (656) auf dem Zielstrukturelement (602), und
wobei das Anpassen auf dem simulierten Signal an dem Kontrollpunkt (656) und der Zuordnung von Maskenpunkten (503, 604, 606, 658) zu dem Kontrollpunkt (656) basiert.

4. Computerlesbares Medium gemäß Anspruch 2, wobei das Bestimmen der Kostenfunktion (521) Folgendes umfasst:
Durchführen einer Simulation mit dem modifizierten Entwurf (525, 902a, 902b), um ein simuliertes Bild zu erhalten;
Erhalten des Prozessfensters unter Verwendung des simulierten Bildes, wobei das Prozessfenster einen Bereich von Fokus- und Dosiswerten umfasst, für den das auf ein Substrat (W) unter Verwendung des modifizierten Entwurfs (525, 902a, 902b) gedruckte Zielmuster (501) eine vorgegebene Spezifikation einhält.

5. Computerlesbares Medium gemäß Anspruch 2, wobei die Kostenfunktion (521) mindestens eines von einem Kantenplatzierungsfehler, einem simulierten Signal, einem Prozessfenster oder einem Strafmaß für die Verletzung einer Maskenregelprüfung umfasst.

6. Computerlesbares Medium gemäß Anspruch 1, wobei das Anpassen der Orte der Maskenpunkte (503, 604, 606, 658) Folgendes umfasst:
Modifizieren von Zuordnungen zwischen den Maskenpunkten (503, 604, 606, 658) und den Kontrollpunkten (656) für eine nächste Iteration der Maskenpunktanpassung.

7. Computerlesbares Medium gemäß Anspruch 1, wobei ein oder mehrere Kontrollpunkte (656) auf dem Zielstrukturelement (602) in mindestens zwei Iterationen einem unterschiedlichen Satz Maskenpunkten zugeordnet sind.

8. Computerlesbares Medium gemäß Anspruch 1, das ferner Folgendes beinhaltet:
Anwenden eines Glättungsprozesses auf die Maskenpunkte (503, 604, 606, 658), wobei der Glättungsprozess eine Kurvenangleichung durchführt, um die Maskenpunkte (503, 604, 606, 658) mit Kurven zu verbinden, um den Entwurf (509) der Musterungsvorrichtung als ein erstes kurvenförmiges Muster zu erzeugen.

9. Computerlesbares Medium gemäß Anspruch 8, das ferner Folgendes beinhaltet:
Durchführen einer Bildperturbation an dem Entwurf (509) der Musterungsvorrichtung, um eine vergrößerte Version des Entwurfs (511) zu erzeugen.

10. Computerlesbares Medium gemäß Anspruch 2, wobei das Anpassen des Ortes eines oder mehrerer der Maskenpunkte (503, 604, 606, 658) das kohärente Anpassen eines Satzes der Maskenpunkte (503, 604, 606, 658) umfasst.

11. Computerlesbares Medium gemäß Anspruch 2, wobei das Anpassen des Ortes eines oder mehrerer der Maskenpunkte (503, 604, 606, 658) das individuelle Anpassen jedes einzelnen eines Satzes der Maskenpunkte (503, 604, 606, 658) umfasst.

12. Computerlesbares Medium gemäß Anspruch 2, wobei die Ortsdaten jedes Maskenpunktes einen Richtungskoeffizientenwert und einen Abstandswert umfassen, anhand derer eine Ortsanpassung des entsprechenden Maskenpunkts in Bezug auf einen Kontrollpunkt (656), dem der entsprechende Maskenpunkt zugeordnet ist, durchgeführt werden soll.

13. Computerlesbares Medium gemäß Anspruch 1, wobei der Entwurf (511) aus einem oder mehreren von Folgendem resultiert: auf maschinellem Lernen, ML, basierender optischer Nahbereichskorrektur, OPC, Freeform OPC mit Maske mit kontinuierlicher Transmission, CTM, CTM+ Freeform OPC, segmentbasierter OPC und Inverse-Lithographie-Technologie.

14. Computerlesbares Medium gemäß Anspruch 1, wobei das Maskenstrukturelement ein Hilfsstrukturelement unterhalb der Auflösungsgrenze oder ein Hauptstrukturelement ist.

## Revendications

1. Un support lisible par ordinateur non transitoire ayant des instructions qui, lorsqu'elles sont exécutées par un ordinateur, amènent l'ordinateur à exécuter une méthode pour améliorer un dessin (509, 511) d'un dispositif servant à conformer selon un motif, la méthode comprenant :
l'obtention de points de masque (503, 604, 606, 658) du dessin (509, 511) d'une caractéristique de masque, où la caractéristique de masque est associée à une caractéristique cible (602) dans un motif cible (501) à imprimer sur un substrat (W) ; et
l'ajustement de localisations des points de masque (503, 604, 606, 658) afin de générer un dessin modifié (525, 902a, 902b) de la caractéristique de masque sur la base des points de masque (503, 604, 606, 658) ajustés,
où l'obtention des points de masque (503, 604, 606, 658) inclut :
la dérivation des points de masque (503, 604, 606, 658) à partir de la caractéristique cible (602), où la dérivation comprend l'association des points de masque (503, 604, 606, 658) avec des points de contrôle (656) sur la caractéristique cible (602) afin de générer une première association entre un premier ensemble de points de masque (658) et un premier point de contrôle (656) et une deuxième association entre un deuxième ensemble de points de masque et un deuxième point de contrôle.

2. Le support lisible par ordinateur de la revendication 1, où l'ajustement de localisations des points de masque (503, 604, 606, 658) est un procédé itératif, où chaque itération inclut :
la détermination d'une fonction de coût (521) associée à un procédé de correction de proximité optique ou un procédé d'optimisation source masque,
la détermination, pour chaque point de contrôle (656) sur la caractéristique cible (602), de données de localisation des points de masque (503, 604, 606, 658) sur la base de la fonction de coût (521), et
l'ajustement d'une localisation d'un ou de plusieurs des points de masque (503, 604, 606, 658) sur la base des données de localisation afin d'optimiser la fonction de coût (521), où l'ajustement inclut la mise à jour du dessin modifié (525, 902a, 902b).

3. Le support lisible par ordinateur de la revendication 2, où la détermination de la fonction de coût (521) inclut :
la réalisation d'une simulation avec le dessin modifié (525, 902a, 902b) afin d'obtenir un signal d'image de réserve ou un signal d'image de gravure comme signal simulé, et
la détermination du signal simulé pour chaque point de contrôle (656) sur la caractéristique cible (602), et
où l'ajustement est basé sur le signal simulé au niveau du point de contrôle (656) et l'association de points de masque (503, 604, 606, 658) avec le point de contrôle (656).

4. Le support lisible par ordinateur de la revendication 2, où la détermination de la fonction de coût (521) inclut :
la réalisation d'une simulation avec le dessin modifié (525, 902a, 902b) afin d'obtenir une image simulée ;
l'obtention de la fenêtre de procédé en utilisant l'image simulée, où la fenêtre de procédé inclut une gamme de valeurs de focus et dose pour lesquelles le motif cible (501) imprimé sur un substrat (W) en utilisant le dessin modifié (525, 902a, 902b) satisfait une spécification prédéterminée.

5. Le support lisible par ordinateur de la revendication 2, où la fonction de coût (521) inclut au moins un élément parmi une erreur de placement de bord, un signal simulé, une fenêtre de procédé, ou une pénalité pour violation des règles MRC (*Mask Rule Check*, vérification des règles pour le masque).

6. Le support lisible par ordinateur de la revendication 1, où l'ajustement des localisations des points de masque (503, 604, 606, 658) inclut :
la modification d'associations entre les points de masque (503, 604, 606, 658) et les points de contrôle (656) pour une prochaine itération d'ajustement de point de masque.

7. Le support lisible par ordinateur de la revendication 1, où un ou plusieurs points de contrôle (656) sur la caractéristique cible (602) sont associés à un ensemble différent de points de masque dans au moins deux itérations.

8. Le support lisible par ordinateur de la revendication 1, comprenant en sus :
l'application d'un procédé de lissage aux points de masque (503, 604, 606, 658), où le procédé de lissage réalise une adaptation de courbe pour relier les points de masque (503, 604, 606, 658) avec des courbes afin de générer le dessin (509) du dispositif servant à conformer selon un motif comme un premier motif curvilinéaire.

9. Le support lisible par ordinateur de la revendication 8 comprenant en sus :
la réalisation d'une perturbation d'image sur le dessin (509) du dispositif servant à conformer selon un motif afin de générer une version agrandie du dessin (511).

10. Le support lisible par ordinateur de la revendication 2, où l'ajustement de la localisation d'un ou de plusieurs des points de masque (503, 604, 606, 658) inclut l'ajustement d'un ensemble des points de masque (503, 604, 606, 658) de manière cohérente.

11. Le support lisible par ordinateur de la revendication 2, où l'ajustement de la localisation d'un ou de plusieurs des points de masque (503, 604, 606, 658) inclut l'ajustement de chaque point d'un ensemble des points de masque (503, 604, 606, 658) de manière individuelle.

12. Le support lisible par ordinateur de la revendication 2, où les données de localisation de chaque point de masque incluent une valeur de pente et une valeur de distance par lesquelles un ajustement de localisation du point de masque correspondant doit être réalisé relativement à un point de contrôle (656) avec lequel le point de masque correspondant est associé.

13. Le support lisible par ordinateur de la revendication 1, où le dessin (511) est le résultat d'un ou de plusieurs procédés parmi : l'OPC (*Optical Proximity Correction*, correction de proximité optique) basé sur ML (*Machine Learning*, apprentissage machine), l'OPC Freeform avec CTM (*Continuous Transmission Mask*, masque à transmission continue), l'OPC Freeform avec CTM+, l'OPC à base segment, et la technologie de lithographie inverse.

14. Le support lisible par ordinateur de la revendication 1, où la caractéristique de masque est une caractéristique auxiliaire sub-résolution ou une caractéristique principale.
